# EUROPÄISCHE PATENTSCHRIFT

(11) **EP 1 872 476 B1**
(45) Veröffentlichungstag und Bekanntmachung des Hinweises auf die Patenterteilung: **02.07.2008**
(21) Anmeldenummer: 06705988.1
(22) Anmeldetag: 18.02.2006
(51) Int. Cl.: H03K 17/18

(54) **VERFAHREN UND VORRICHTUNG ZUR ERKENNUNG EINER AN EIN RELAIS ANGESCHLOSSENEN LAST**
METHOD AND DEVICE FOR RECOGNISING A LOAD WHICH IS CONNECTED TO A RELAY
PROCEDE ET DISPOSITIF POUR RECONNAITRE UNE CHARGE CONNECTEE A UN RELAIS

(30) Priorität: 14.04.2005 DE 102005017135
(43) Veröffentlichungstag der Anmeldung: 02.01.2008
(73) Patentinhaber: Conti Temic microelectronic GmbH, 90411 Nürnberg (DE)
(72) Erfinder: LAUTER, Harald, 88339 Bad Waldsee/Kümmerazhofen (DE)
(86) Internationale Anmeldenummer: PCT/DE2006/000304
(87) Internationale Veröffentlichungsnummer: WO 2006/108371

(56) Entgegenhaltungen:
- US-A- 4 675 560

## Beschreibung

Die Erfindung betrifft ein Verfahren und eine Vorrichtung zur Erkennung eines an einem Wechselkontakt eines Relais angeschlossenen Verbrauchers.

Für Diagnosezwecke ist es erforderlich, elektrisch zu erkennen, ob an einem Relais oder einer Relaisbrücke ein Verbraucher angeschlossen ist. Eine solche Erkennung kann insbesondere vor mechanischen Abläufen eingesetzt werden, an denen mehrere Stellelemente als Verbraucher beteiligt sind, beispielsweise in Form von Elektromotoren. Wenn vor einem derartigen Ablauf erkannt wird, dass ein Stellelement nicht angeschlossen ist, wird der gesamte Ablauf gesperrt.

Beispielsweise braucht ein Bewegungsablauf zum automatischen Öffnen eines Verdecks eines Cabriolets nicht begonnen zu werden, wenn bereits vor Beginn des Bewegungsablaufs erkannt werden kann, dass Fensterhebermotoren oder eine Verschlusskralle, welche für das automatische Öffnen des Daches erforderlich sind, nicht einsatzfähig sind.

Im Stand der Technik wird zur Erkennung eines an ein Relais angeschlossenen Verbrauchers ein Messwiderstand als Shunt in Reihe mit dem Verbraucher geschaltet. Über einen Spannungsabfall am Messwiderstand kann mittels einer Auswerteschaltung ein fließender Laststrom ermittelt werden, der das Vorhandensein einer angeschlossenen Last signalisiert. Die Auswertung wird in der Regel mittels eines Mikrocontrollers durchgeführt.

Dieses Vorgehen ist wegen des erforderlichen Messwiderstands und der Auswerteschaltung aufwendig. Mittels einer Strommessung kann das Vorhandensein eines Motors erst überprüft werden, wenn das Relais bereits einige Millisekunden eingeschaltet ist. Dann ist jedoch zum Zeitpunkt der Erkennung der Motor unerwünschterweise bereits angelaufen. Für eine Strommessung ist außerdem ein freier Analogeingang an einem Mikrocontroller erforderlich. Analogeingänge können nicht ohne Aufwand zusammengeschaltet werden. Bei zwei Motorenendstufen sind daher beispielsweise auch zwei Analogeingänge erforderlich.

US 4675560 offenbart eine Testschaltung mit einem Halbleitertransistor als Schalter.

Der Erfindung liegt daher die Aufgabe zugrunde, ein verbessertes Verfahren und eine verbesserte Vorrichtung der eingangs genannten Art anzugeben, bei denen die genannten Nachteile vermieden werden.

Erfindungsgemäß wird die Aufgabe durch ein Verfahren, welches die in Anspruch 1 angegebenen Merkmale aufweist, und durch eine Vorrichtung, welche die in Anspruch 6 angegebenen Merkmale aufweist, gelöst.

Vorteilhafte Ausgestaltungen der Erfindung sind Gegenstand der Unteransprüche.

Das erfindungsgemäße Verfahren sieht vor, dass in einem kontaktlosen Zeitraum während eines Schaltens des Relais mittels einer Testspannung in einem Stromkreis des Verbrauchers identifiziert wird, ob ein Verbraucher angeschlossen ist. Hierzu wird vorzugsweise geprüft, ob in dem Stromkreis des Verbrauchers zumindest ein Teil der Testspannung abfällt. Bei einem durch den Verbraucher geschlossenen Stromkreis kann ein Spannungsabfall festgestellt werden, anderenfalls nicht. Dies ermöglicht ein Erkennen des Verbrauchers mit geringem Aufwand. Ein fließender Laststrom ist nicht erforderlich. Bereits mit dem Ende des Relaisschaltvorgangs steht anhand eines eventuellen Spannungsabfalls fest, ob ein Verbraucher angeschlossen und durchgängig ist.

Dabei wird vorteilhafterweise zum Identifizieren des Spannungsabfalls das zeitliche Verhalten eines Spannungsimpulses an einer Stelle des Stromkreises des Verbrauchers mit vorgebbaren Vergleichswerten verglichen.

In einer bevorzugten Ausgestaltung wird eine negative Testspannung verwendet. Die Testspannung kann mit geringem Aufwand aus einer Betriebsspannung des Relais und/oder des Verbrauchers erzeugt werden.

In der erfindungsgemäßen Vorrichtung sind eine Spannungsquelle für eine Testspannung und ein Widerstand in Reihe mit dem Verbraucher geschaltet. Eine Prüfvorrichtung zum Identifizieren eines im Stromkreis des Verbrauchers auftretenden Spannungsabfalls ist zudem mit dem Widerstand verbunden.

Vorzugsweise ist die Spannungsquelle als Kondensator ausgebildet. In einer mit geringem Aufwand herstellbaren Ausführungsform ist die Prüfvorrichtung als Mikrocontroller ausgebildet. In einer bevorzugten Ausgestaltung ist dabei der Mikrokontroller über einen Komparator mit dem Widerstand verbunden.

Zweckmäßigerweise stimmt die Testspannung mit einer Betriebsspannung des Relais und/oder des Verbrauchers überein.

In einer besonderen Ausführungsform ist das Relais als erstes Relais einer Relaisbrücke ausgebildet. Dabei ist zweckmäßigerweise das erste Relais für eine erste Polung des Verbrauchers und ein zweites Relais der Relaisbrücke für eine -zweite Polung des Verbrauchers vorgesehen.

Eine bevorzugte Ausgestaltung sieht vor, dass für das zweite Relais eine zweite Spannungsquelle für eine Testspannung und ein zweiter Widerstand in Reihe mit dem Verbraucher geschaltet sind.

Vorteilhafterweiser ist die Prüfvorrichtung zum Identifizieren eines im Stromkreis des Verbrauchers auftretenden Spannungsabfalls mit dem zweiten Widerstand verbunden.

Die mit der Erfindung erzielten Vorteile bestehen insbesondere darin, dass durch Identifizieren eines angeschlossenen Verbrauchers im Zeitpunkt des Umschaltens von Relaiskontakten kein fließender Laststrom erforderlich ist. Somit kann ein angeschlossener Verbraucher mit weitgehend geringem Aufwand identifiziert werden. Insbesondere können alle an einem mechanischen Ablauf beteiligte Verbraucher vorab in einer Diagnoseroutine auf ihren Anschluss geprüft werden.

Ausführungsbeispiele der Erfindung werden anhand von Zeichnungen näher erläutert. Darin zeigen:
- Fig. 1: ein Schaltbild einer Vorrichtung mit einem Relais und
- Fig. 2: ein Schaltbild einer Vorrichtung mit Relaisbrücke.

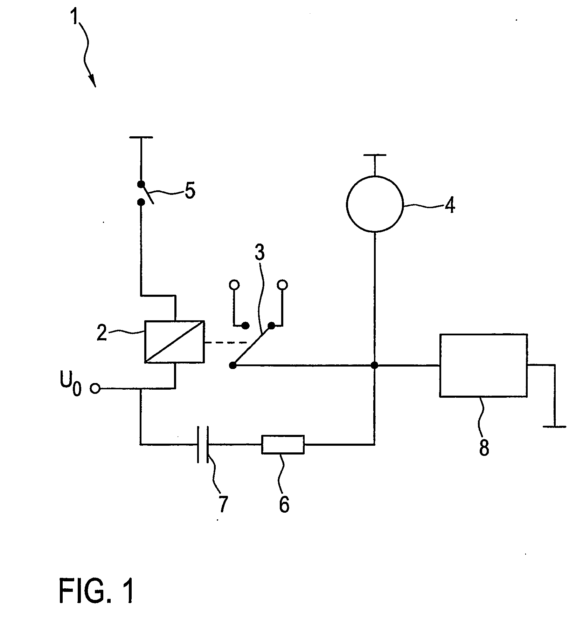

Figur 1 zeigt eine Ausführungsform einer Vorrichtung 1 mit einem einzelnen Relais 2, an dessen Wechselkontakt 3 ein Verbraucher 4 angeschlossen ist. Das Relais 2 ist in diesem einfachen Fall über einen Schalter 5 schaltbar. Der Verbraucher 4 ist über einen Widerstand 6 und einen Kondensator 7 mit der Betriebsspannung U₀ verbunden.

Zwischen dem Verbraucher 4 und dem Widerstand 6 ist eine Prüfvorrichtung 8 angeschlossen, die Spannungsimpulse an dem Knotenpunkt zwischen Verbraucher 4 und Widerstand 6 auswertet.

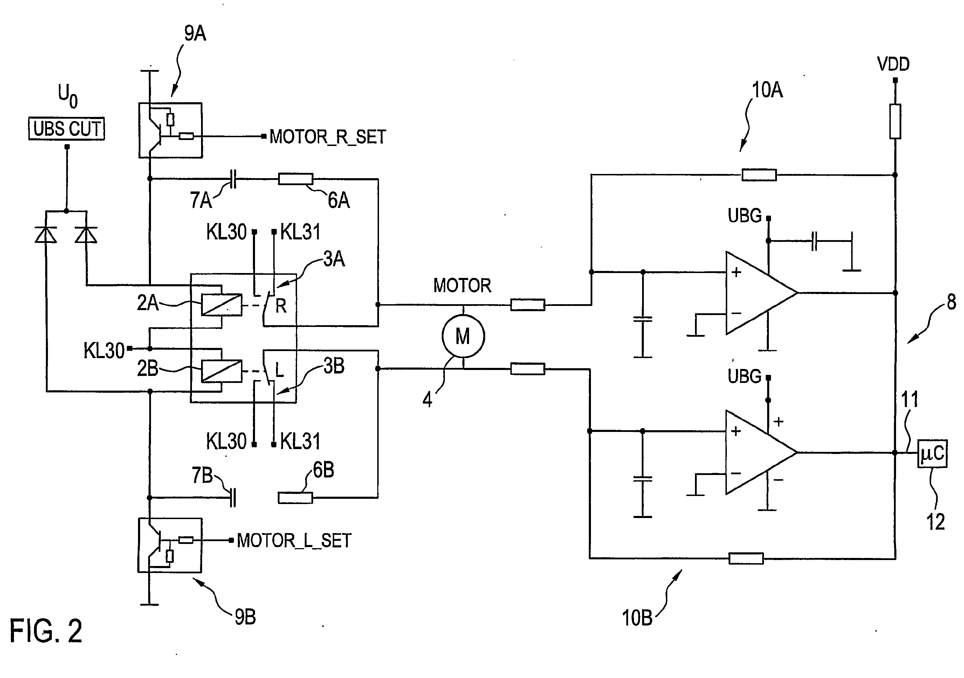

Figur 2 zeigt den komplexeren Fall einer Relaisbrücke eines Fensterhebers. Hier werden ein erstes Relais 2A und ein zweites Relais 2B mit jeweiligen Wechselkontakten 3A und 3B von je einem Schalttransistor 9A, 9B gesteuert. Ein als Fensterhebermotor ausgeführter Verbraucher 4 ist mit den Wechselkontakten der Relais 2A, 2B verbunden. Das erste Relais 2A ist für einen Rechtslauf des Motors vorgesehen, das zweite Relais 2B für einen Linkslauf.

Der Verbraucher 4 ist einerseits über einen ersten Widerstand 6A und einen ersten Kondensator 7A und andererseits über einen zweiten Widerstand 6B und einen zweiten Kondensator 7B mit der Betriebsspannung U₀=+12 V verbunden, die an den Klemmen KL30 der Relais 2A, 2B anliegt. Die Widerstände 6A, 6B und Kondensatoren 7A, 7B entsprechen dabei in ihrer Funktion dem Widerstand 6 und dem Kondensator 7 der in Figur 1 gezeigten Schaltung.

Die Anschlüsse des Verbrauchers 4 sind über separate Komparatorschaltungen 10A, 10B mit einem Eingang 11 eines abgebildeten Mikrocontrollers 12 verbunden. Die Komparatorschaltungen 10A, 10B und der Mikrokontroller 12 dienen dabei als Prüfvorrichtung 8.

Die Funktionsweise der in den Figuren 1 und 2 dargestellten Schaltungen beruht auf dem Anlegen einer Testspannung im Stromkreis des Verbrauchers 4 in einem Zeitraum, in dem ein Relais 2A, 2B gerade am Umschalten ist. In diesem Zeitraum ist einer der beiden Anschlüsse des Verbrauchers 4 mit keinem Potential verbunden. Zweckmäßigerweise wird eine negative Testspannung angelegt, um die Testspannung von einer Antriebsspannung für den Verbraucher 4 deutlich zu unterscheiden.

Im Ruhezustand liegen die Klemmen KL31 der Relais 2A, 2B auf Masse. Es ist keines der Relais 2A, 2B angezogen. Der Verbraucher 4 ist an beiden Anschlüssen mit Masse verbunden.

Die Kondensatoren 7A, 7B zwischen Verbraucher 4 und Betriebsspannung U₀ werden aufgeladen.

Wird das erste Relais 2A für den Rechtslauf bei unterbrochener Last durch den zugehörigen Schalttransistor 9A angesteuert, so springt die Spannung an der Spule des ersten Relais 2A von U₀ auf Masse. Der aufgeladene Kondensator 7A kann sich nicht sofort entladen. Er erzeugt daher für kurze Zeit am relaisseitigen Anschluss des Verbrauchers 4 eine negative Spannung von -12 V. Zugleich schaltet das erste Relais 2A für den Rechtslauf.

Für die Dauer des Schaltvorgangs liegt das Potential des Wechselkontakts 3A in der Luft. Der Schaltvorgang des Wechselkontakts 3A dauert etwa 500 µs. Während dieser Zeit fällt am Widerstand 6A keine Spannung ab. Das Potential des Wechselkontakts 3A springt auf -12 V. Die Komparatorschaltung 10A identifiziert für die Zeit von etwa 500 µs einen negativen Spannungsimpuls und gibt diesen auf den Eingang 11, z. B. einen Timer-Eingang, des Mikrocontrollers 12. Mittels des Mikrocontrollers 12 wird die Qualität des Impulses, insbesondere das zeitliche Verhalten des Spannungsimpulses, mit vorgebbaren Vergleichswerten verglichen und so ein nicht angeschlossener Verbraucher wie folgt identifiziert.

Ist ein Verbraucher 4 angeschlossen, so springt die Spannung an der Spule des ersten Relais 2A von der Betriebsspannung U₀ nach der Ansteuerung durch den zugehörigen Schalttransistor 9A auf Masse. Der aufgeladene Kondensator 7A kann sich auch in diesem Fall nicht sofort entladen. Er erzeugt daher für kurze Zeit am relaisseitigen Anschluss des Verbrauchers 4 eine negative Spannung von -12 V. Zugleich schaltet das erste Relais 2A für den Rechtslauf. Für die Dauer des Schaltvorgangs liegt das Potential des Wechselkontakts 3A über die Last des Verbrauchers 4 und das zweite Relais 2B niederohmig auf Masse. Die negative Spannung des Kondensators 7A fällt am Widerstand 6A ab. Die Komparatorschaltung 10A identifiziert keine negative Spannung und schaltet nicht. Mittels des Mikrocontrollers 12 wird in diesem Fall ein angeschlossener Verbraucher 4 identifiziert.

### Bezugszeichenliste

- 1: Vorrichtung
- 2: Relais
- 2A: Erstes Relais
- 2B: Zweites Relais
- 3 , 3A, 3B: Wechselkontakt
- 4: Verbraucher
- 5: Schalter
- 6: Widerstand
- 6A: Erster Widerstand
- 6B: Zweiter Widerstand
- 7: Kondensator
- 7A: Erster Kondensator
- 7B: Zweiter Kondensator
- 8: Prüfvorrichtung
- 9,9A,9B: Schalttransistor
- 10A,10B: Komparatorschaltung
- 11: Timer-Eingang

- KL30: Klemme
- KL31: Klemme

- U₀: Betriebsspannung

## Patentansprüche

1. Verfahren zur Erkennung eines an einem Wechselkontakt (3, 3A, 3B) eines elektromechanischen Relais (2, 2A, 2B) angeschlossenen Verbrauchers (4), wobei im Schaltvorgang der Wechselkontakt von einer Spule von einem ersten zu einem zweiten Kontakt bewegt und in dem kontaktlosen Zeitraum während des Schaltens des Relais (2, 2A, 2B) mittels einer Testspannung geprüft wird, ob der Verbraucher (4) angeschlossen ist.

2. Verfahren nach Anspruch 1, wobei während des Schaltens des Relais (2, 2A, 2B) geprüft wird, ob im Stromkreis des Verbrauchers (4) zumindest ein Teil der Testspannung abfällt.

3. Verfahren nach Anspruch 2, **dadurch gekennzeichnet, dass** zum Identifizieren des Spannungsabfalls das zeitliche Verhalten eines Spannungsimpulses an einer Stelle des Stromkreises des Verbrauchers (4) mit vorgebbaren Vergleichswerten verglichen wird.

4. Verfahren nach einem der Ansprüche 1 bis 3, **dadurch gekennzeichnet, dass** eine negative Testspannung verwendet wird.

5. Verfahren nach einem der Ansprüche 1 bis 4, **dadurch gekennzeichnet, dass** die Testspannung aus einer Betriebsspannung (U₀) des Relais (2, 2A, 2B) und/oder des Verbrauchers (4) erzeugt wird.

6. Elektromechanisches Relais (2, 2A, 2B) mit einem Wechselkontakt und einer Vorrichtung zur Erkennung eines an dem Wechselkontakt (3, 3A, 3B) angeschlossenen Verbraucher (4) zur Durchführung eines Verfahrens nach einem der Ansprüche 1 bis 5, wobei eine Spannungsquelle für eine Testspannung und ein Widerstand (6, 6A, 6B) in Reihe mit dem Verbraucher (4) geschaltet sind und eine Prüfvorrichtung (8) zum Identifizieren eines im Stromkreis des Verbrauchers (4) auftretenden Spannungsabfalls mit dem Widerstand (6, 6A, 6B) verbunden ist, welche in dem kontaktlosen Zeitraum während des Schaltens des Relais (2, 2A, 2B) mittels einer Testspannung prüft, ob der Verbraucher (4) angeschlossen ist.

7. Elektromechanisches Relais nach Anspruch 6, **dadurch gekennzeichnet, dass** die Spannungsquelle als Kondensator (7, 7A, 7B) ausgebildet ist.

8. Elektromechanisches Relais nach Anspruch 6 oder 7, **dadurch gekennzeichnet, dass** die Prüfvorrichtung (8) als Mikrocontroller (12) ausgebildet ist.

9. Elektromechanisches Relais nach Anspruch 8, **dadurch gekennzeichnet, dass** der Mikrocontroller (12) über einen Komparator (10A, 10B) mit dem Widerstand (6A, 6B) verbunden ist.

10. Elektromechanisches Relais nach einem der Ansprüche 6 bis 9, **dadurch gekennzeichnet, dass** die Testspannung mit einer Betriebsspannung (U₀) des Relais (2, 2A, 2B) und/oder des Verbrauchers (4) übereinstimmt.

11. Elektromechanisches Relais nach einem der Ansprüche 6 bis 10, **dadurch gekennzeichnet, dass** das Relais (2A) als erstes Relais einer Relaisbrücke (2A, 2B) ausgebildet ist.

12. Elektromechanisches Relais nach Anspruch 11, **dadurch gekennzeichnet, dass** das erste Relais (2A) für eine erste Polung des Verbrauchers (4) und ein zweites Relais (2B) der Relaisbrücke (2A, 2B) für eine zweite Polung des Verbrauchers (4) vorgesehen ist.

13. Elektromechanisches Relais nach Anspruch 12, **dadurch gekennzeichnet, dass** für das zweite Relais (2B) eine zweite Spannungsquelle für eine Testspannung und ein zweiter Widerstand (6B) in Reihe mit dem Verbraucher (4) geschaltet sind.

14. Elektromechanisches Relais nach Anspruch 13, **dadurch gekennzeichnet, dass** die Prüfvorrichtung (8) zum Identifizieren eines im Stromkreis des Verbrauchers (4) auftretenden Spannungsabfalls mit dem zweiten Widerstand (6B) verbunden ist.

## Claims

1. A method for detecting a consumer (4) which is connected to a change-over contact (3, 3A, 3B) of an electro-mechanical relay (2, 2A, 2B), wherein in the switching procedure, the change-over contact is moved from a coil from a first to a second contact, and in the contactless time period during the switching of the relay (2, 2A, 2B), a test voltage is used to check whether the consumer (4) is connected.

2. A method according to claim 1, wherein during the switching of the relay (2, 2A, 2B), a check is made as to whether in the current circuit of the consumer (4) at least one part of the test voltage drops.

3. A method according to claim 2, **characterized in that** in order to identify the voltage drop, the time behaviour of a voltage impulse is compared at one point in the current circuit of the consumer (4) with specifiable comparative values.

4. A method according to any one of claims 1 to 3, **characterized in that** a negative test voltage is used.

5. A method according to any one of claims 1 to 4, **characterized in that** the test voltage is generated from an operating voltage (U₀) of the relay (2, 2A, 2B) and/or of the consumer (4).

6. An electro-mechanical relay (2, 2A, 2B) with a change-over contact and a device for detecting a consumer (4) which is connected to the change-over contact (3, 3A, 3B) for implementing a method according to any one of claims 1 to 5, wherein a voltage source for a test voltage and a resistance (6, 6A, 6B) are switched in series with the consumer (4) and a test device (8) for identifying a voltage drop which occurs in the current circuit of the consumer (4) is connected with the resistance (6, 6A, 6B), which in the contactless time period while the relay (2, 2A, 2B) is being switched checks by means of a test voltage whether the consumer (4) is connected.

7. An electro-mechanical relay according to claim 6, **characterized in that** the voltage source is designed as a capacitor (7, 7A, 7B).

8. An electro-mechanical relay according to either of claims 6 or 7, **characterized in that** the test device (8) is designed as a microcontroller (12).

9. An electro-mechanical relay according to claim 8, **characterized in that** the microcontroller (12) is connected via a comparator (10A, 10B) with the resistance (6A, 6B).

10. An electro-mechanical relay according to any one of claims 6 to 9, **characterized in that** the test voltage corresponds with an operating voltage (U₀) of the relay (2, 2A, 2B) and/or of the consumer (4).

11. An electro-mechanical relay according to any one of claims 6 to 10, **characterized in that** the relay (2A) is designed as the first relay of a relay bridge (2A, 2B).

12. An electro-mechanical relay according to claim 11, **characterized in that** the first relay (2A) is provided for a first polarity of the consumer (4), and a second relay (2B) of the relay bridge (2A, 2B) is provided for a second polarity of the consumer (4).

13. An electro-mechanical relay according to claim 12, **characterized in that** for the second relay (2B), a second voltage source for a test voltage and a second resistance (6B) are switched in series with the consumer (4).

14. An electro-mechanical relay according to claim 13, **characterized in that** the test device (8) for identifying a voltage drop occurring in the current circuit of the consumer (4) is connected with the second resistance (6B).

## Revendications

1. Procédé pour la reconnaissance d'un consommateur (4) connecté à un contact inverseur (3, 3A, 3B) d'un relais électromécanique (2, 2A, 2B), le contact inverseur étant déplacé par une bobine d'un premier à un deuxième contact pendant le processus de commutation et, dans l'intervalle sans contact pendant la commutation du relais (2, 2A, 2B), un contrôle étant effectué au moyen d'une tension de test pour vérifier si le consommateur (4) est connecté.

2. Procédé selon la revendication 1, un contrôle étant effectué pendant la commutation du relais (2, 2A, 2B) pour vérifier si au moins une partie de la tension de test baisse dans le circuit du consommateur (4).

3. Procédé selon la revendication 2, **caractérisé en ce que**, pour l'identification de la chute de tension, le comportement temporel d'une impulsion de tension à un emplacement du circuit du consommateur (4) est comparé avec des valeurs de comparaison spécifiables.

4. Procédé selon l'une des revendications 1 à 3, **caractérisé en ce qu'**une tension de test négative est employée.

5. Procédé selon l'une des revendications 1 à 4, **caractérisé en ce que** la tension de test est générée à partir d'une tension de service (U₀) du relais (2, 2A, 2B) et/ou du consommateur (4).

6. Relais électromagnétique(2, 2A, 2B) avec un contact inverseur et un dispositif pour la reconnaissance d'un consommateur (4) connecté au contact inverseur (3, 3A, 3B) pour l'exécution d'un procédé selon l'une des revendications 1 à 5, une source de tension pour une tension de test et une résistance (6, 6A, 6B) étant connectées en série avec le consommateur (4) et un dispositif de contrôle (8) pour l'identification d'une chute de tension apparaissant dans le circuit du consommateur (4) étant relié avec la résistance (6, 6A, 6B), lequel dispositif contrôle au moyen d'une tension de test dans l'intervalle sans contact pendant la commutation du relais (2, 2A, 2B) si le consommateur (4) est connecté.

7. Relais électromagnétique selon la revendication 6, **caractérisé en ce que** la source de tension est formée comme condensateur (7, 7A, 7B).

8. Relais électromagnétique selon la revendication 6 ou 7, **caractérisé en ce que** le dispositif de contrôle (8) est formé comme microcontrôleur (12).

9. Relais électromagnétique selon la revendication 8, **caractérisé en ce que** le microcontrôleur (12) est relié à la résistance (6A, 6B) par un comparateur (10A, 10B).

10. Relais électromagnétique selon l'une des revendications 6 à 9, **caractérisé en ce que** la tension de test correspond à une tension de service (Uₒ) du relais (2, 2A, 2B) et/ou du consommateur (4).

11. Relais électromagnétique selon l'une des revendications 6 à 10, **caractérisé en ce que** le relais (2A) est formé comme premier relais d'un pont de relais (2A, 2B).

12. Relais électromagnétique selon la revendication 11, **caractérisé en ce que** le premier relais (2A) est prévu pour une première polarité du consommateur (4) et un deuxième relais (2B) du pont de relais (2A, 2B) pour une deuxième polarité du consommateur (4).

13. Relais électromagnétique selon la revendication 12, **caractérisé en ce que**, pour le deuxième relais (2B), une deuxième source de tension pour une tension de test et une deuxième résistance (6B) sont connectées en série avec le consommateur (4).

14. Relais électromagnétique selon la revendication 13, **caractérisé en ce que** le dispositif de contrôle (8) est relié à la deuxième résistance (6B) pour l'identification d'une chute de tension apparaissant dans le circuit du consommateur (4).
